(19) Europäisches Patentamt
European Patent Office
Office européen des brevets

(11) **EP 3 924 742 B1**

(12) **EUROPÄISCHE PATENTSCHRIFT**

(45) Veröffentlichungstag und Bekanntmachung des Hinweises auf die Patenterteilung:
**10.01.2024 Patentblatt 2024/02**

(21) Anmeldenummer: **21709375.6**

(22) Anmeldetag: **01.03.2021**

(51) Internationale Patentklassifikation (IPC):
**G01R 31/367** (2019.01) **G01R 31/3842** (2019.01)
**G01R 31/389** (2019.01)

(52) Gemeinsame Patentklassifikation (CPC):
**G01R 31/367; G01R 31/3842; G01R 31/389**

(86) Internationale Anmeldenummer:
**PCT/EP2021/054982**

(87) Internationale Veröffentlichungsnummer:
**WO 2021/170866 (02.09.2021 Gazette 2021/35)**

(54) **VERFAHREN UND BATTERIEMANAGEMENTSYSTEM ZUR ÜBERWACHUNG EINES BATTERIESYSTEMS DURCH IMPEDANZBESTIMMUNG**

METHOD AND BATTERY MANAGEMENT SYSTEM FOR MONITORING A BATTERY SYSTEM BY DETERMINING IMPEDANCE

PROCÉDÉ ET SYSTÈME DE GESTION DE BATTERIE PERMETTANT DE SURVEILLER UN SYSTÈME DE BATTERIE PAR DÉTERMINATION D'IMPÉDANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.02.2020 DE 102020105349**

(43) Veröffentlichungstag der Anmeldung:
**22.12.2021 Patentblatt 2021/51**

(73) Patentinhaber: **TWAICE Technologies GmbH**
**80807 München (DE)**

(72) Erfinder:
• **BAUMANN, Michael**
**80805 München (DE)**
• **KARGER, Alexander**
**81667 München (DE)**
• **MAHESHWARI, Arpit**
**81371 München (DE)**

(74) Vertreter: **Neusser, Sebastian**
**Kraus & Weisert**
**Patentanwälte PartGmbB**
**Thomas-Wimmer-Ring 15**
**80539 München (DE)**

(56) Entgegenhaltungen:
**GB-A- 2 532 726 US-B1- 10 502 791**

**Beschreibung**

Mit zunehmender Verbreitung von Batteriesystemen als Energiequelle für Transportfahrzeuge kommt der Analyse des Alterungsverhaltens dieser Batteriesysteme steigende Bedeutung zu. Die Alterung der Batteriesysteme zeigt sich insbesondere in einer geänderten Impedanz der Batteriesysteme und deren Frequenzverlauf. Es besteht daher der Wunsch, die Impedanz des jeweiligen Batteriesystems im Betrieb laufend zu überwachen.

M. Baumann, S. Rohr und M. Lienkamp schlagen zu diesem Zweck im Artikel "Cloud-connected battery management for decision making on Second-Life of electric vehicle batteries", DOI: 10.1109/EVER.2018.8362355 einen Ansatz zur nicht-rekursiven Bestimmung von Impedanzparametern eines elektrischen Modells eines Batteriesystems vor. Dabei werden als Messfenster bezeichnete endliche Folgen von Messparametern zunächst gespeichert und basierend auf diesen Messfenstern eine Bestimmung der Impedanzparametern vorgenommen. Das elektrische Modell kann auch als elektrisches Ersatzmodell bezeichnet werden. Das elektrische Modell des Batteriesystems kann insbesondere durch ein elektrisches Ersatzschaltbild veranschaulicht werden.

Aufgabe der vorliegenden Erfindung ist es, das bekannte Verfahren zu verbessern. Insbesondere wird eine verbesserte Bestimmung der Parameter des elektrischen Ersatzmodells im laufenden Betrieb gewünscht.

GB 2 532 726 A offenbart einen Diagnosesystem für eine interne Impedanz eines Batteriespeichersystems. Es wird ein Ersatzschaltkreismodell verwendet.

Erfindungsgemäß werden ein Verfahren nach dem unabhängigen Anspruch 1 und ein Batteriemanagementsystem nach dem unabhängigen Anspruch 9 vorgeschlagen. Vorteilhafte Ausgestaltungen sind in den Unteransprüchen angeführt.

Vorgeschlagen wird ein Verfahren zum Betreiben eines Batteriemanagementsystems zur Überwachung eines Batteriesystems. Das Verfahren umfasst das Bereitstellen einer Folge von zeitlich aufeinanderfolgenden Paaren aus gemessenen Strom- und Spannungswerten. Die Paare aus Strom- und Spannungswerten geben den durch das Batteriesystem fließenden Strom und die am Batteriesystem anliegende Spannung an. Weiter sieht das Verfahren ein Bereitstellen eines elektrischen Ersatzmodells des Batteriesystems vor. Das elektrische Ersatzmodell weist mehrere in Reihe geschaltete Impedanzen auf. Für die Impedanzen des elektrischen Ersatzmodells werden initiale Impedanzparameterwerte bereitgestellt. Das Verfahren sieht ein Anpassen eines ersten Impedanzparameters einer Impedanz des elektrischen Ersatzmodells basierend auf der Differenz zwischen einem ersten, auf Basis der initialen Impedanzparameterwerte und des ersten Stromwerts der endlichen Folge, simuliertem Spannungswert und dem ersten gemessenen Spannungswert der endlichen Folge vor. Dadurch wird ein optimierter erster Impedanzparameterwert erhalten. Durch Minimierung der Abweichung einer auf Grundlage des elektrischen Ersatzmodells und der Folge von gemessenen Stromwerten erhaltenen Folge simulierter Spannungswerte von der Folge gemessener Spannungswerten durch Anpassen wenigstens eines weiteren Impedanzparameters der Impedanzen des elektrischen Ersatzmodells wird wenigstens ein optimierter weiterer Impedanzparameterwert des wenigstens einen weiteren Impedanzparameters erhalten.

Bei dem Batteriesystem kann es sich um eine einzelne Batteriezelle handeln. In dem Fall können die Paare aus Strom- und Spannungswerten den durch diese Batteriezelle fließenden Strom und die an dieser Batteriezelle anliegenden Spannung angeben. Das Batteriesystem kann allerdings auch mehrere Batteriezellen umfassen. Die Batteriezellen können dabei parallel geschaltet sein. Die Paare aus Strom- und Spannungswerten können dann den durch die parallel geschalteten Batteriezellen fließenden Strom und die an den parallel geschalteten Batteriezellen anliegende Spannung angeben. Die Batteriezellen können auch in Serie geschaltet sein. Die Paare aus Strom- und Spannungswerten können in dem Fall den durch die in Serie geschalteten Batteriezellen fließenden Strom und die an den über die ganzen in Serie geschalteten Batteriezellen abfallende Spannung angeben. Ebenso ist es denkbar, dass das Batteriesystem mehrere parallel geschaltete Teilsysteme aus in Serie geschalteten Batteriezellen oder mehrere in Serie geschaltete Teilsystem aus parallel geschalteten Batteriezellen aufweist. Ein Batteriesystem im vorbeschriebenen Sinne kann auch ein Teilsystem eines größeren Batteriesystems sein.

Es ist auch denkbar nicht nur Paare aus Strom- und Spannungswerten, sondern auch weitere den aktuellen Zustand des Batteriesystems beschreibende Messwerte bereitzustellen. Beispielsweise kann zu jedem der Paare aus Strom- und Spannungswerten auch die Temperatur des Batteriesystems zum entsprechenden Zeitpunkt bereitgestellt werden.

Das Bereitstellen der Messwerte kann ein Messen der entsprechenden Werte umfassen. Allerdings ist es auch denkbar, dass bereits gemessene und gespeicherte Werte verwendet werden. Die Messwerte können beispielsweise zunächst am Ort des Batteriesystems gemessen, dort zwischengespeichert und im Anschluss über eine drahtgebundene oder drahtlose Kommunikationsstelle zu einem anderen System übertragen werden.

Die initialen Impedanzparameterwerte können zufällige Impedanzparameterwerte sein. Die initialen Impedanzparameterwerte können allerdings auch auf Erfahrungswerten von Batteriesystemen mit ähnlichem Aufbau beruhen. Insbesondere können die initialen Impedanzparameterwerte auch auf Labormessungen von Batteriesystemen des gleichen oder ähnlichen Typs des zu überwachenden Batteriesystems zurückgehen.

Im Rahmen des Verfahrens können bei der Minimierung der Abweichung nicht nur ein weiterer Impedanzparameter, sondern mehrere weitere Impedanzparameter, insbesondere sämtliche weitere Impedanzparameter angepasst werden. Der eine weitere Impedanzparameter oder die mehreren weiteren Impedanzparameter können insbesondere Impedanzen des elektrischen Ersatzmodells mit geringeren Zeitkonstanten zugeordnet sein.

In einer Ausgestaltung des Verfahrens wird der erste Impedanzparameter durch Addition eines Produktes der Differenz mit einer Konstanten zum initialen Impedanzparameter erhalten.

Eine solche einfache Rechnung kann es erlauben, das Verfahren in Echtzeit durchzuführen.

Weiter sieht ein Ausführungsbeispiel des Verfahrens vor, dass bei der Minimierung der Abweichung eine basierend auf den initialen Parameterwerten, dem ersten gemessenen Stromwert und dem ersten gemessenen Spannungswert berechnete Korrekturspannung verwendet wird.

Ferner weist in einer Ausgestaltung des Verfahrens wenigstens eine Impedanz des elektrischen Ersatzmodells einen stromabhängigen Widerstand auf.

Dies kann einen Ladungsübertragungswiderstand des Batteriesystems abbilden, so dass das elektrische Ersatzmodell das Batteriesystem realistischer darstellt.

In einer Ausgestaltung des Verfahrens wird bei der Minimierung der Abweichung ein Trust-Region-Verfahren verwendet. Dies kann die Bestimmung der Impedanzparameterwerte bei dem gegebenen nichtlinearen Optimierungsproblem weiter vereinfachen.

Dies kann es zudem erlauben, bei der Minimierung der Abweichung für den optimierten weiteren Impedanzwert des wenigstens einen weiteren Impedanzparameters einen realistischeren Wert zu erhalten, der das reale Batteriesystem besser abbildet. Die Verwendung eines Trust-Region-Verfahrens kann in einigen Ausgestaltungen auch die erforderliche Rechenzeit zur Minimierung der Abweichung verringern helfen.

Weiter ist in einem Ausführungsbeispiel vorgesehen, dass die endliche Folge aus einer längeren Folge von Paaren aus gemessenen Strom- und Spannungswerten ausgewählt wird, und dass als erstes Paar der endlichen Folge ein Paar der längeren Folge nach einer vorbestimmten Anzahl von Paaren der längeren Folge gewählt wird, bei denen der Stromwert im Wesentlichen konstant bleibt oder der Betrag des Quotienten aus Stromwert und einer Nennkapazität, wobei der Quotient auch als C-Rate bezeichnet wird, des Batteriesystems geringer ist als eine vorbestimmte maximale C-Rate.

Bei der längeren Folge kann es sich insbesondere um Paare aus gemessenen Strom- und Spannungswerten handeln, welche kontinuierlich im laufenden Betrieb gemessen werden, insbesondere in einem kontinuierlichen Datenfluss während des Betriebs, bei dem es kein definiertes Ende gibt. Solange Strom- und Spannungswerte gemessen werden, wird die betrachtete Zeitreihe quasi unendlich fortgesetzt. Typischerweise wird immer nur eine längere Folge von Paaren aus Strom- und Spannungswerten definierter Länge aus dem kontinuierlichen Datenfluss betrachtet. Die längere Folge umfasst mehr Paare aus gemessenen Strom- und Spannungswerten als die endliche Folge.

Dies kann es ermöglichen, dass die Bestimmung des optimierten ersten Impedanzparameterwerts und des optimierten weiteren Impedanzparameterwerts möglichst unabhängig von Strom- und Spannungswerten, die nicht Teil der endlichen Folge sind, ausgestaltet werden kann.

Ferner umfasst in einer Ausführungsform die endliche Folge eine Teilfolge vorbestimmter Länge, für die der Betrag des Quotienten aus Stromwert und der Nennkapazität des Batteriesystems höher ist als eine vorbestimmte minimale C-Rate ($C_{Rmin}$).

Dies kann das Risiko, dass nicht alle physikalischen Effekte, welche die Impedanz eines Batteriesystems bestimmen und die im elektrochemischen Ersatzmodell abgebildet werden, ausreichend angeregt sind, verringern. Auf diese Weise kann eine genauere Bestimmung der Impedanzparameterwerte des elektrischen Ersatzmodells ermöglicht werden.

Ein Ausführungsbeispiel des Verfahrens sieht vor, dass der optimierte erste Impedanzparameter und der oder die optimierten weiteren Impedanzparameter als initiale Impedanzparameterwerte einer nachfolgenden endlichen Folge verwendet werden.

Typischerweise ist die Änderung der Impedanzparameterwerte eines Batteriesystems innerhalb eines kurzen Zeitraum eher gering. Die Verwendung der in einer ersten Iteration des Verfahrens bestimmten Impedanzparameterwerte als initiale Impedanzparameterwerte für die nachfolgende Iteration, kann die Bestimmung der optimierten Impedanzparameterwerte in der nachfolgenden Iteration beschleunigen.

Weiter wird ein Batteriemanagementsystem vorgeschlagen, welches zur Durchführung eines der voranstehend beschriebenen Verfahren eingerichtet ist. Das Batteriemanagementsystem kann dabei am Ort des Batteriesystems zum Einsatz kommen. Ebenso ist es allerdings denkbar, dass Batteriesystem an einem vom Batteriesystem getrennten Ort vorzusehen. Beispielsweise kann das Batteriemanagementsystem durch einen Server realisiert sein, der die Messwerte über eine drahtlose oder drahtgebundene Kommunikationseinreichung vom Batteriemanagementsystem erhält. Die Messwerte können dabei am Ort des Batteriesystems oder in der Cloud zwischengespeichert sein.

Erfindungsgemäß umfasst das Batteriemanagementsystem Mittel zum Messen der Paare aus gemessenen Strom- und Spannungswerten und in einem Ausführungsbeispiel einen Speicher zum Speichern der endlichen Folge der Paare. Der Speicher kann insbesondere einen Ringspeicher aufweisen. Ebenfalls denkbar ist ein Speichern der Messwerte in der Cloud.

Ausführungsbeispiele werden im Folgenden mit Hilfe der Zeichnungen veranschaulicht. Dabei zeigt

Fig. 1 ein Beispiel eines elektrischen Ersatzmodells;
Fig. 2 ein Beispiel eines Batteriemanagementsystems;
Fig. 3 eine exemplarische Folge von Strom- und Spannungspaaren; und
Fig. 4 einen Ausschnitt der Folge aus Fig. 3.

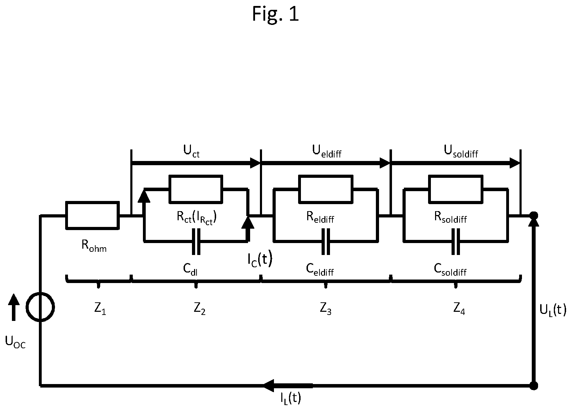

In der Fig. 1 ist ein Beispiel eines elektrischen Ersatzmodells dargestellt, welches für die Überwachung eines Batteriesystems verwendet werden kann. Das elektrische Ersatzmodell umfasst eine ideale Spannungsquelle, welche eine Quellenspannung Uoc bereitstellt sowie vier in Reihe geschaltete Impedanzen $Z_1$, $Z_2$, $Z_3$ und $Z_4$.

Bei der Impedanz $Z_1$ handelt es sich dabei um einen rein ohmschen Widerstand $R_{ohm}$ und bei den Impedanzen $Z_2$, $Z_3$ und $Z_4$ um RC-Glieder. Das elektrische Ersatzmodell kann auch eine geringere oder größere Menge in Reihe geschalteter Impedanzen aufweisen. Ebenso ist es denkbar, dass die Impedanzen alternativ oder ergänzend zu den RC-Gliedern auch andere Impedanzglieder umfassen. Beispielsweise können die Impedanzen des elektrischen Ersatzmodells auch Konstantphasenelemente (constant phase element, CPE), insbesondere Warburg-Elemente, und/oder ZARC-Elemente aufweisen.

In dem in der Fig. 1 gezeigten Ausführungsbeispiel umfasst die Impedanz $Z_1$ einen stromabhängigen Widerstand $R_{ct}(I_{R_{ct}})$, welcher den Widerstand beim Ladungstransfer abbildet, und eine Kapazität $C_{dl}$, welche die Doppelschichtkapazität des Batteriesystems abbildet. Die Impedanz $Z_2$ weist einen Widerstand $R_{eldiff}$ und eine Kapazität $C_{eldiff}$ auf und repräsentiert elektrolytische Diffusionsprozesse im Batteriesystem. Die Impedanz $Z_3$ umfasst einen Widerstand $R_{soldiff}$ und eine Kapazität $C_{soldiff}$ und repräsentiert Festkörperdiffusionseffekt.

Dabei ist zu beachten, dass das elektrische Ersatzmodell nicht exakt die physikalischen Vorgänge beschreibt, sondern nur an diese angelehnt ist, um das Batteriesystem sinnvoll parametrisieren zu können.

Die über der Last abfallende, vom Batteriesystem bereitgestellte Spannung $U_L(t)$ setzt sich aus der Quellenspannung $U_{oc}(t)$ der idealen Spannungsquelle und den Spannungen über den einzelnen Impedanzen $Z_1$, $Z_2$, $Z_3$, $Z_4$ des Ersatzschaltkreises zusammen und lässt sich wie folgt ausdrücken:

$$(1) \quad U_L(t) = U_{OC}(t) + R_{ohm}I_L(t) + U_{ct}(t) + U_{eldiff}(t) + U_{soldiff}(t)$$

In diskreter Form kann die vom Batteriesystem zum Zeitpunkt k bereitgestellte Spannung $U_{L,k}$ wie folgt ausgedrückt werden:

$$(2) \quad U_{L,k} = U_{OC,k} + R_{ohm}I_{L,k} + U_{ct,k} + U_{eldiff,k} + U_{soldiff,k}$$

Dabei gilt

$$(3) \quad U_{ct,k} = U_{1,k-1}e^{\frac{-\Delta t_k}{R_{ct,k}C_{dl}}} + R_{ct,k} \cdot I_{L,k}\left(1 - e^{\frac{\Delta t_k}{R_{ct,k}C_{dl}}}\right) = U_{ct,k-1}e^{\frac{-\Delta t_k}{\tau_{ctdl}}} + R_{ct,k} \cdot$$

$$I_{L,k}\left(1 - e^{\frac{\Delta t_k}{\tau_{ctdl}}}\right)$$

mit

$$(4) \quad R_{ct,k} = R_1\left(\frac{\ln\left(k_1(I_{L,k}-I_{C,k-1}) + \sqrt{\left(k_1(I_{L,k}-I_{C,k-1})\right)^2 + 1}\right)}{k_1(I_{L,k}-I_{C,k-1})}\right)$$

und

4

$$(5) \qquad I_{C,k} = I_{L,k} - \frac{U_{1,k}}{R_{ct,k}}$$

sowie

$$(6) \qquad U_{eldiff,k} = U_{eldiff,k-1} e^{\frac{-\Delta t_k}{R_{eldiff} C_{eldiff}}} + R_{eldiff} \cdot I_{L,k} \left( 1 - e^{\frac{\Delta t_k}{R_{eldiff} C_{eldiff}}} \right)$$

$$= U_{eldiff,k-1} e^{\frac{-\Delta t_k}{\tau_{eldiff}}} + R_{eldiff} \cdot I_{L,k} \left( 1 - e^{\frac{\Delta t_k}{\tau_{eldiff}}} \right)$$

und

$$(7) \qquad U_{solldiff,k} = U_{solldiff,k-1} e^{\frac{-\Delta t_k}{R_{solldiff} C_{solldiff}}} + R_{solldiff} \cdot I_{L,k} \left( 1 - e^{\frac{\Delta t_k}{R_{solldiff} C_{solldiff}}} \right)$$

$$= U_{solldiff,k-1} e^{\frac{-\Delta t_k}{\tau_{solldiff}}} + R_{solldiff} \cdot I_{L,k} \left( 1 - e^{\frac{\Delta t_k}{\tau_{solldiff}}} \right)$$

Das elektrische Ersatzmodell kann folglich mit dem Parametersatz

$$\mathbf{P} = \left\{ R_{ohm}, R_1, k_1, C_{dl}, R_{eldiff}, C_{eldiff}, R_{solldiff}, C_{solldiff} \right\}$$

bzw.

$$\mathbf{P} = \left\{ R_{ohm}, R_1, k_1, \tau_{ctl}, R_{eldiff}, \tau_{eldiff}, R_{solldiff}, \tau_{solldiff} \right\}$$

beschrieben werden.

Die numerische Stabilität des Systems kann erhöht werden, indem bei der Anpassung des elektrischen Ersatzmodells an real gemessene Messwerte die Zeitkonstanten $\tau_{ctl}$, $\tau_{eldiff}$, $\tau_{solldiff}$ nicht bestimmt werden, so dass das elektrische Ersatzmodell mit dem reduzierten Parametersatz

$$\mathbf{P_{sim}} = \left\{ R_{ohm}, R_1, k_1, R_{eldiff}, R_{solldiff} \right\}$$

beschrieben werden kann. In einigen Ausführungsbeispielen kann angenommen werden, dass sich die Zeitkonstanten $\tau_{ctl}$, $\tau_{eldiff}$, $\tau_{solldiff}$ im Rahmen der Alterung des Batteriesystems nur geringfügig ändern. Die Zeitkonstanten $\tau_{ctl}$, $\tau_{eldiff}$, $\tau_{solldiff}$ können für das zu untersuchende Batteriesystem vorab im Rahmen von Labormessungen bestimmt werden. Es ist aber auch denkbar, dass sich die Zeitkonstanten $\tau_{ctl}$, $\tau_{eldiff}$, $\tau_{solldiff}$ im Laufe der Zeit ändern, und dies bei der Überwachung des Batteriesystems zu berücksichtigen.

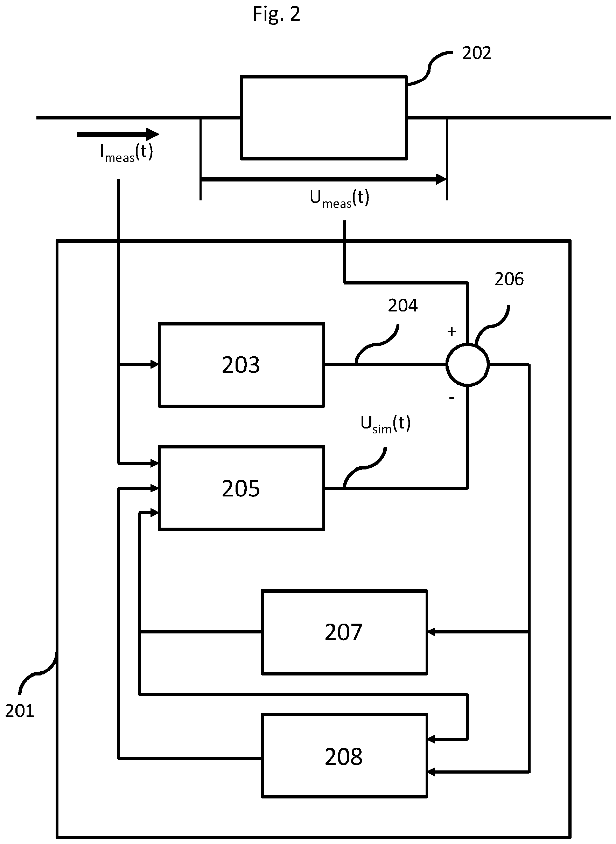

Wie in Fig. 2 angedeutet kann ein Batteriemanagementsystem 201 den durch ein Batteriesystem 202 fließenden Strom $I_{meas}(t)$ und die vom Batteriesystem 202 bereitgestellte Spannung $U_{meas}(t)$ messen.

Die Messungen können insbesondere aufeinanderfolgend zu diskreten Zeitpunkten $t_n$ mit $n \in [1, N]$ vorgenommen, so dass eine kontinuierliche Folge von Messpaaren $(I_{meas,n}; U_{meas,n}) = (I_{meas}(t_n); U_{meas}(t_n))$ erhalten wird.

Alternativ können die Messpaare auch separat erhalten werden und dem Batteriemanagementsystem beispielsweise mittels einer kabellosen Datenübertragung zur Verfügung gestellt werden.

Unter einem Batteriemanagementsystem 201 kann ein beliebiges System verstanden werden, welches dazu eingerichtet ist ein Batteriesystem zu überwachen. Das Batteriemanagementsystem 201 kann beispielsweise mehrere voneinander getrennte Komponenten aufweisen, die über kabellose oder kabelgebundene Schnittstellen miteinander kommunizieren. Insbesondere kann das Batteriemanagementsystem 201 einen Observer aufweisen, welcher dazu eingerichtet ist Impedanzparameterwerte eines elektrischen Ersatzmodells des Batteriesystems zu bestimmen. Das Batteriemanagementsystem 201 kann beispielsweise dazu eingerichtet sein, Änderungen dieser Impedanzparameterwerte aufgrund von Alterungseffekten zu bestimmen.

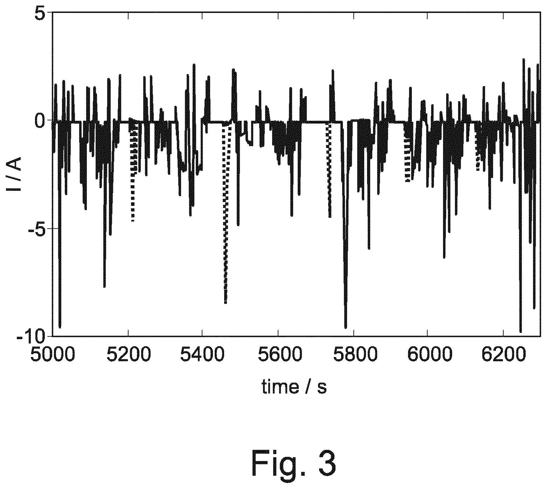

Fig. 3 zeigt eine Folge von Messwerten $I_{meas,n}$ des Stroms I in Ampere über der Zeit t in Stunden für das beispielhafte Batteriesystem 202. Bei dem Batteriesystem 202 kann es sich beispielsweise, um ein Batteriesystem 202 eines elektrischen Kraftfahrzeuges handeln, wobei die Messwerte $I_{meas,n}$ den Strom angeben, der zur Beschleunigung des Kraftfahrzeugs dient bzw. bei der Rekuperation beim Abbremsen des Kraftfahrzeugs wieder dem Batteriesystem 202 zugefügt wird.

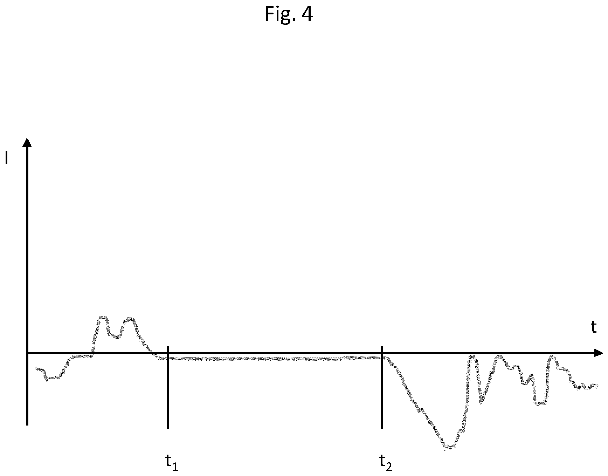

Fig. 4 zeigt eine Teilfolge der Folge von Messwerten $I_{meas,n}$ des Stroms I in Ampere über der Zeit t in Sekunden.

Wie voranstehend ausgeführt wird dem Batteriemanagementsystem 201 eine Folge von Paaren aus gemessenen Strom- und Spannungswerten zur Verfügung gestellt. Aus dieser längeren Folge von Paaren aus gemessenen Strom- und Spannungswerten wird eine endliche Folge von Paaren aus gemessenen Strom- und Spannungswerten ausgewählt.

In der Fig. 3 sind Beispiele für aus der längeren Folge gewählte endliche Folgen gepunktet hervorgehoben. Die gewählten endlichen Folgen können auch als Fenster bezeichnet werden.

Als erstes Paar der endlichen Folge kann ein Paar der längeren Folge nach einer vorbestimmten Anzahl von Paaren der längeren Folge gewählt werden, bei denen der Stromwert im Wesentlichen konstant bleibt oder der Betrag des Quotienten aus Stromwert und der Nennkapazität des Batteriesystems 202 geringer ist als eine vorbestimmte maximale C-Rate $C_{max}$.

Fig. 4 zeigt einen Ausschnitt der in der Fig. 3 gezeigten längeren Folge, welcher eine endliche Folge umfasst. Von einem Zeitpunkt $t_1$ bis zu einem Zeitpunkt $t_2$ bleibt der Stromwert I in etwa konstant. Insbesondere bleibt der Betrag des Quotienten aus Stromwert und der Nennkapazität des Batteriesystems 202 geringer als eine vorbestimmt maximale C-Rate $C_{max}$. Als erstes Paar der endlichen Folge kann folglich das erste Paar nach dem Zeitpunkt $t_2$ der in der Fig. 4 dargestellten Folge gewählt werden. Die gewählte endliche Folge umfasst auch eine Teilfolge vorbestimmter Länge, für die der Betrag des Quotienten aus Stromwert und der Nennkapazität des Batteriesystems höher ist als eine vorbestimmte minimale C-Rate $C_{min}$.

Zur Auswahl der endlichen Folge kann eine Fensterbestimmungseinheit 203 verwendet werden. die Fensterbestimmungseinheit 203 kann ein Trigger-Signal 204 generieren, welches einen Start der Bestimmung der Impedanzparameter veranlasst.

Hierzu kann das System eine Modelleinheit 205 aufweisen, die dazu eingerichtet ist, basierend auf dem gemessenen Strom $I_{meas}$ einen simulierten Spannungsabfall über dem Batteriesystem 202 $U_{sim}(t)$ zu berechnen. Mit der Modelleinheit 205 kann insbesondere ein elektrisches Ersatzmodell des Batteriesystems 202 wie es oben beschrieben wurde abgebildet werden. Hierzu können der Modelleinheit 205 initiale Impedanzparameterwerte bereitgestellt werden.

Eine Differenz zwischen der gemessenen Spannung $U_{meas}(t_1)$ und der simulierten Spannung $U_{sim}(t_1)$ für das erste Wertepaar der endlichen Folge kann für die Bestimmung eines optimierten ersten Impedanzparameterwerts verwendet werden. Hierzu kann das Batteriemanagementsystem 201 eine Niederfrequenzanpassungseinheit 207 aufweisen.

Der erste Impedanzparameter kann der Widerstand $R_{soldiff}$ des oben angegebenen elektrischen Ersatzmodells sein. Der erste Impedanzparameter kann durch Addition eines Produktes der Differenz der Spannungen mit dem initialen ersten Impedanzparamterwert und einer Konstanten angepasst werden, um einen optimierten ersten Impedanzparameterwert zu erhalten:

$$(8) \qquad R_{soldiff,opt} = R_{soldiff,init} + R_{soldiff,init} * \left( U_{meas(t_1)} - U_{sim(t_1)} \right) * K_p$$

Der optimierte erste Impedanzparameterwert kann dann bei der Anpassung der weiteren Impedanzparameterwerte verwendet werden. Die Berechnung des optimierten ersten Impedanzparameterwerts nach Formel (8) kann auch mehrfach wiederholt werden, wobei für die Bestimmung von $U_{sim(t_1)}$ der in der vorangehenden Iteration bestimmt optimierte Impedanzparameterwert $R_{soldiff,opt}$ und die initialen anderen Impedanzparameterwerte verwendet werden.

Weiter kann das Batteriesystem 201 eine Hochfrequenzanpassungeinheit 208 aufweisen. Die Hochfrequenzeinheit 208 kann dazu eingerichtet sein, basierend auf der endlichen Folge die weiteren Impedanzparameterwerte zu bestimmen.

Der mittlere quadratische Fehler des Gesamtmodells kann bestimmt sein durch

$$(9) \qquad E_{RMS} = \sqrt{\frac{\sum_{k=1}^{K}\left(U_{L,k} - U_{meas,k}\right)^2}{K}}$$

Zur Minimierung des Einflusses von überlagerten Diffusionsparametern kann eine Diffusionsüberspannung

eingeführt werden:

$$(10) \quad U_{err,2} = U_{OC,1} + R_{ohm}I_{L,1} + U_{ct,1} + U_{eldiff,1} - U_{meas,1}$$

Dies kann es erlauben den Einfluss von überlagerten Diffusionsparametern beim Minimieren der Abweichung gering zu halten.

Dabei kann angenommen werden, dass die Diffusionsüberspannung $U_{err,2}$ während der Zeit der endlichen Folge konstant bleibt.

Zur Bestimmung der weiteren optimierten Parameterwerte kann dann die folgende Kostenfunktion minimiert werden:

$$(11) \quad f_{cost} = \sum_{k=1}^{K}\left(U_{L,k} - U_{meas,k} - U_{err,2}\right)^2 \to min.$$

Auf diese Weise können die weiteren optimierten Parameterwerte erhalten werden. Grundsätzlich ist es auch denkbar, die Bestimmung der weiteren optimierten Parameterwerte mit Hilfe einer anderen Kostenfunktion zu bestimmen, die die Abweichung ($U_{L,k}$ - $U_{meas,k}$ - $U_{err,2}$) minimiert.

Zusammenfassend erlaubt das vorgeschlagene Verfahren eine Überwachung eines Batteriesystems, wobei die Impedanzparameter eines elektrischen Ersatzmodells bestimmt werden können. Dabei erlaubt es die Trennung der Bestimmung eines ersten Impedanzparameterwerts, der einer Impedanz mit einer hohen Zeitkonstante zugeordnet sein kann, von der Bestimmung des wenigstens einen Impedanzparameterwerts, der einer Impedanz mit einer niedrigen Zeitkonstante zugeordnet sein kann, eine genauere und schnellere Bestimmung der Impedanzparameterwerte.

**Patentansprüche**

1. Verfahren zum Betreiben eines Batteriemanagementsystems zur Überwachung eines Batteriesystems (202) umfassend:

   - Bereitstellen einer endlichen Folge von zeitlich aufeinanderfolgenden Paaren aus gemessenen Strom- und Spannungswerten ($I_{meas,k}$; $U_{meas,k}$), wobei die Paare aus Strom- und Spannungswerten ($I_k$; $U_k$) den durch das Batteriesystem (202) fließenden Strom ($I_L$) und die am Batteriesystem (202) anliegende Spannung ($U_L$) zum entsprechenden Zeitpunkt angeben;
   - Bereitstellen eines elektrischen Ersatzmodells des Batteriesystems (202), wobei das elektrische Ersatzmodell in Reihe geschaltete Impedanzen ($Z_1$, $Z_2$, $Z_3$, $Z_4$) aufweist;
   - Bereitstellen von initialen Impedanzparameterwerten der Impedanzen des elektrischen Ersatzmodells;

   **dadurch gekennzeichnet, dass** das Verfahren weiterhin umfasst:

   - Anpassen eines ersten Impedanzparameters (Rsoldif) einer Impedanz (Z4) des elektrischen Ersatzmodells basierend auf der Differenz zwischen einem ersten, auf Basis der initialen Impedanzparameterwerte und des ersten Stromwerts ($I_1$) der endlichen Folge simulierten Spannungswerts ($U_{sim,1}$) und dem ersten gemessenen Spannungswert ($U_{meas,1}$) der endlichen Folge, wodurch ein optimierter erster Impedanzparameterwert erhalten wird;
   - Minimierung der Abweichung einer auf Grundlage des elektrischen Ersatzmodells und der Folge von gemessenen Stromwerten ($I_{meas,k}$) erhaltenen Folge simulierter Spannungswerte ($U_{sim,k}$) von der Folge gemessener Spannungswerte ($U_{meas,k}$) durch Anpassen wenigstens eines weiteren Impedanzparameters der Impedanzen ($Z_1$, $Z_2$, $Z_3$, $Z_4$) des elektrischen Ersatzmodells, wodurch ein optimierter weiterer Impedanzparameterwert des wenigstens einen weiteren Impedanzparameters erhalten wird.

2. Verfahren nach Patentanspruch 1,
   wobei der erste Impedanzparameter ($R_{soldif}$) durch Addition eines Produktes der Differenz mit dem initialen ersten Impedanzparameterwert und 2. einer Konstanten zum initialen ersten Impedanzparameterwert angepasst wird.

3. Verfahren nach einem der Patentansprüche 1 oder 2,
   wobei bei der Minimierung der Abweichung eine basierend auf den initialen Parameterwerten, dem ersten gemessenen Stromwert und dem ersten gemessenen Spannungswert berechnete Korrekturspannung verwendet wird.

**4.** Verfahren nach einem der Patentansprüche 1 bis 3,
wobei wenigstens eine Impedanz einen stromabhängigen Widerstand aufweist.

**5.** Verfahren nach einem der Patentansprüche 1 bis 4,
wobei bei der Minimierung der Abweichung ein Trust-Region-Verfahren verwendet wird.

**6.** Verfahren nach einem der Patentansprüche 1 bis 5,

wobei die endliche Folge aus einer längeren Folge von Paaren aus gemessenen Strom- und Spannungswerten ($I_{meas,k}$; $U_{meas,k}$) ausgewählt wird, und
wobei als erstes Paar der endlichen Folge ein Paar der längeren Folge nach einer vorbestimmten Anzahl von Paaren der längeren Folge gewählt wird, bei denen der Stromwert im Wesentlichen konstant bleibt oder der Betrag des Quotienten aus Stromwert und einer Nennkapazität des Batteriesystems (202) geringer ist als eine vorbestimmte maximale C-Rate ($C_{max}$).

**7.** Verfahren nach Patentanspruch 5,
wobei die endliche Folge eine Teilfolge vorbestimmter Länge umfasst, für die der Betrag des Quotienten aus Stromwert und der Nennkapazität des Batteriesystems (202) höher ist als eine vorbestimmte minimale C-Rate (Cmin).

**8.** Verfahren nach einem der Patentansprüche 1 bis 7,
wobei der optimierte erste Impedanzparameterwert und der optimierte weitere Impedanzparameterwert als initiale Impedanzparameterwerte einer nachfolgenden endlichen Folge verwendet werden.

**9.** Batteriemanagementsystem (201), wobei das Batteriemanagementsystem (201) Mittel zum Messen der Paare aus gemessenen Strom- und Spannungswerten umfasst und zur Durchführung eines Verfahrens nach einem der Patentansprüche 1 bis 8 eingerichtet ist.

**10.** Batteriemanagementsystem (201) nach Patentanspruch 9, wobei das Batteriemanagementsystem (201) ferner umfasst:

- einen Speicher zum Speichern der endlichen Folge der Paare.

**11.** Batteriemanagementsystem (201) nach Patentanspruch 10, wobei der Speicher einen Ringspeicher aufweist.

**Claims**

**1.** Method of operating a battery management system for monitoring a battery system (202) comprising:

- Providing a finite sequence of time-successive pairs of measured current and voltage values ($I_{meas,k}$; $U_{meas,k}$), the pairs of current and voltage values ($I_k$; $U_k$) indicating the current ($I_L$) flowing through the battery system (202) and the voltage ($U_L$) applied to the battery system (202) at the corresponding time ;
- Providing an electrical equivalent model of the battery system (202), the electrical equivalent model comprising series-connected impedances ($Z_1$, $Z_2$, $Z_3$, $Z_4$);
- Providing initial impedance parameter values of the impedances of the electric equivalent model;

**characterized in that** the method further comprises:

- adjusting a first impedance parameter ($R_{soldif}$) of an impedance ($Z_4$) of the electrical equivalent model based on the difference between a first simulated voltage value ($U_{sim,1}$) based on the initial impedance parameter values and the first current value ($I_1$) of the finite sequence and the first measured voltage value ($U_{meas,1}$) of the finite sequence, whereby an optimised first impedance parameter value is obtained;
- Minimising the deviation of a sequence of simulated voltage values ($U_{sim,k}$) obtained based on the electrical equivalent model and the sequence of measured current values ($I_{meas,k}$) from the sequence of measured voltage values ($U_{meas,k}$) by adjusting at least one further impedance parameter of the impedances ($Z_1$, $Z_2$, $Z_3$, $Z_4$) of the electrical equivalent model, whereby an optimized further impedance parameter value of the at least one further impedance parameter is obtained.

**2.** Method according to claim 1,
wherein the first impedance parameter ($R_{soidif}$) is adjusted by adding a product of the difference with the initial first impedance parameter value and a constant to the initial first impedance parameter value.

**3.** Method according to claim 1 or 2,
wherein a correction voltage calculated based on the initial parameter values, the first measured current value and the first measured voltage value is used when minimising the deviation.

**4.** Method according to any one of the claims 1 to 3,
wherein at least one impedance comprises a current-dependent resistance.

**5.** Method according to any one of the claims 1 to 4,
wherein a trust-region-method is used when minimising the deviation.

**6.** Method according to any one of the claims 1 to 5,

wherein the finite sequence is selected from a longer sequence of pairs of measured current and voltage values ($I_{meas,k}$; $U_{meas,k}$), and
wherein the first pair of the finite sequence is selected from a pair of the longer sequence according to a predetermined number of pairs of the longer sequence in which the current value remains substantially constant or the quotient value of current value and a nominal capacity of the battery system (202) is less than a predetermined maximum C-rate ($C_{max}$).

**7.** Method according to claim 5,
wherein the finite sequence comprises a subsequence of predetermined length, for which the quotient value of current value and the nominal capacity of the battery system (202) is greater than a predetermined minimum C-rate (Cmin).

**8.** Method according to any one of the claims 1 to 7,
wherein the optimised first impedance parameter value and the optimised further impedance parameter value are used as initial impedance parameter values of a subsequent finite sequence.

**9.** A battery management system (201), wherein the battery management system (201) comprises means for measuring the pairs of measured current and voltage values and is configured to perform a method according to any one of claims 1 to 8.

**10.** A battery management system (201) according to claim 9, wherein the battery management system (201) further comprises:

- a memory for storing the finite sequence of pairs.

**11.** A battery management system (201) according to patent claim 10, wherein the memory comprises a ring memory.

**Revendications**

**1.** Procédé de fonctionnement d'un système de gestion de batterie destiné à surveiller un système de batterie (202) comprenant les étapes suivantes :

- fournir une séquence finie de paires temporellement successives de valeurs de courant et de tension mesurées ($I_{meas,k}$ ; $U_{meas,k}$), les paires de valeurs de courant et de tension ($I_k$ ; $U_k$) indiquant le courant ($I_L$) circulant à travers le système de batterie (202) et la tension ($U_L$) appliquée sur le système de batterie (202) à l'instant correspondant ;
- fournir un modèle électrique équivalent du système de batterie (202), le modèle électrique de remplacement comportant des impédances ($Z_1$, $Z_2$, $Z_3$, $Z_4$) montées en série ;
- fournir des valeurs de paramètre d'impédance initiales des impédances du modèle électrique équivalent ;

**caractérisé en ce que** le procédé comprend en outre :

- ajuster un premier paramètre d'impédance (Rsoldif) d'une impédance (Z4) du modèle électrique équivalent sur la base de la différence entre une première valeur de tension ($U_{sim,1}$) simulée sur la base des valeurs de paramètre d'impédance initiales et de la première valeur de courant ($I_1$) de la séquence finie et la première valeur de tension mesurée ($U_{meas,1}$) de la séquence finie, ce qui donne une première valeur de paramètre d'impédance optimisée ;

- minimiser l'écart d'une séquence de valeurs de tension simulées ($U_{sim,k}$), obtenue sur la base du modèle électrique équivalent et de la séquence de valeurs de courant mesurées ($I_{meas,k}$) par rapport à la séquence de valeurs de tension mesurées ($U_{meas,k}$) par ajustement d'au moins un autre paramètre d'impédance des impédances ($Z_1$, $Z_2$, $Z_3$, $Z_4$) du modèle électrique équivalent, ce qui donne une autre valeur de paramètre d'impédance optimisée de l'au moins un autre paramètre d'impédance.

2. Procédé selon la revendication 1,
le premier paramètre d'impédance ($R_{soldif}$) étant ajusté par ajout d'un produit de la différence avec la première valeur de paramètre d'impédance initiale et une constante à la première valeur de paramètre d'impédance initiale.

3. Procédé selon l'une des revendications 1 ou 2,
une tension de correction calculée sur la base des valeurs de paramètre initiales, de la première valeur de courant mesurée et de la première valeur de tension mesurée étant utilisée lors de la minimisation de l'écart.

4. Procédé selon l'une des revendications 1 à 3,
au moins une impédance comportant une résistance dépendant du courant.

5. Procédé selon l'une des revendications 1 à 4,
un procédé de région de confiance étant utilisé lors de la minimisation de l'écart.

6. Procédé selon l'une des revendications 1 à 5,

la séquence finie étant sélectionnée parmi une séquence longue de paires de valeurs de courant et de tension mesurées ($I_{meas,k}$ ; $U_{meas,k}$), et
une paire de la séquence longue étant sélectionnée comme première paire de la séquence finie après un nombre prédéterminé de paires de la séquence longue dans lesquelles la valeur de courant reste sensiblement constante ou la valeur absolue du quotient de la valeur de courant et d'une capacité nominale du système de batterie (202) est inférieure à un taux C maximum prédéterminé ($C_{max}$).

7. Procédé selon la revendication 5,
la séquence finie comprenant une sous-séquence de longueur prédéterminée pour laquelle la valeur absolue du quotient de la valeur de courant et de la capacité nominale du système de batterie (202) est supérieure à un taux C minimum prédéterminé ($C_{min}$).

8. Procédé selon l'une des revendications 1 à 7,
la première valeur de paramètre d'impédance optimisée et l'autre valeur de paramètre d'impédance optimisée étant utilisées comme valeurs de paramètre d'impédance initiales d'une séquence finie ultérieure.

9. Système de gestion de batterie (201), le système de gestion de batterie (201) comprenant des moyens de mesure des paires de valeurs de courant et de tension mesurées et étant conçu pour mettre en œuvre un procédé selon l'une des revendications 1 à 8.

10. Système de gestion de batterie (201) selon la revendication 9, le système de gestion de batterie (201) comprenant en outre :

- une mémoire destinée à mémoriser la séquence finie de paires.

11. Système de gestion de batterie (201) selon la revendication 10, la mémoire comportant une mémoire en anneau.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2532726 A